# DEMANDE DE BREVET EUROPEEN

(11) **EP 4 002 441 A2**
(43) Date de publication de la demande: **25.05.2022**
(21) Numéro de dépôt: 21204895.3
(22) Date de dépôt: 27.10.2021
(51) Int. Cl.: H01L 23/00, H01L 21/66

(54) **CIRCUIT ELECTRONIQUE POUR UN COLLAGE MOLECULAIRE HYBRIDE**

(30) Priorité: 16.11.2020 FR 2011734
(71) Demandeur: Commissariat à l'Energie Atomique et aux Energies Alternatives, 75015 Paris (FR)
(72) Inventeur: BOURJOT, Emilie, 38054 GRENOBLE CEDEX 09 (FR); JOUVE, Amandine, 38054 GRENOBLE CEDEX 09 (FR)
(74) Mandataire: Cabinet Beaumont

(57) **Abrégé**

La présente description concerne un circuit électronique (70) comprenant une face destinée à être fixée à un autre circuit électronique par collage moléculaire hybride. Le circuit électronique comprend une couche isolante électriquement (50) exposée sur la face, et, répartis dans la couche isolante électriquement, des premiers plots de collage (56) conducteurs électriquement exposés sur une première partie de la face, la densité des premiers plots de collage sur la première partie de la face étant inférieure à 30 %, et au moins un plot de test (72) conducteur électriquement, exposé sur une deuxième partie de la face contenant un carré de côté supérieur à 30 µm. La densité de matériau conducteur électriquement du plot de test exposé sur la deuxième partie de la face est comprise entre 40 % et 80 %.

## Description

### Domaine technique

La présente description concerne de façon générale un circuit électronique pour la réalisation d'un collage moléculaire hybride.

### Technique antérieure

Un exemple de procédé de fabrication de dispositifs électroniques comprend la formation de deux plaques de circuits intégrés comprenant chacune une face correspondant à la face libre d'une couche isolante au niveau de laquelle affleurent des plots conducteurs de collage (HBM, sigle anglais pour Hybrid Bonding Metal pads), et la fixation l'une à l'autre de ces faces par collage moléculaire hybride, mettant en contact les plots HBM des deux plaques et les couches isolantes des deux plaques. Les plaques peuvent ensuite être découpées pour séparer les dispositifs électroniques. D'autres exemples comprennent la fixation par collage moléculaire de puces séparées de circuits intégrés à une plaque de circuits intégrés ou la fixation par collage moléculaire d'une puce de circuits intégrés à une autre puce de circuits intégrés.

La réalisation d'un collage moléculaire implique un état de surface adapté, la surface devant notamment respecter des critères exigeants de planéité, de rugosité, et de propreté. L'obtention de cet état de surface adapté implique généralement une étape de planarisation mécanochimique des plaques de circuits intégrés, également appelée CMP (sigle anglais pour Chemical-Mechanical Planarization), qui combine généralement gravure chimique et mécanique. Un tel procédé peut requérir que les différents matériaux présents en surface des plaquettes de circuits intégrés soient répartis de façon sensiblement homogène. C'est pourquoi il est généralement utilisé des plots HBM de mêmes dimensions, par exemple de forme carrée ou hexagonale, répartis de façon sensiblement homogène sur la face, certains plots HBM n'étant pas connectés électriquement à d'autres éléments de la plaque de circuits intégrés et ne servant que pour le collage moléculaire hybride.

La préparation d'un circuit électronique pour la réalisation d'un collage moléculaire hybride comprend la réalisation d'un niveau d'interconnexion supplémentaire sur le circuit électrique d'origine, appelé niveau d'interconnexion de collage, comprenant notamment le dépôt d'un empilement de couches isolantes et la formation des plots HBM dans l'empilement de couches isolantes, certains des plots HBM étant connectés à des plots conducteurs du circuit électronique par des vias conducteurs (HBV, sigle anglais pour Hybrid Bonding Vias) formés dans l'empilement de couches isolantes.

Pour certaines applications, il est souhaitable de pouvoir vérifier le bon fonctionnement du circuit électronique d'origine avant la réalisation du collage moléculaire hybride. Dans ce but, avant la préparation du circuit électronique d'origine au collage moléculaire hybride, il est connu de prévoir des plots conducteurs exposés en surface du circuit électronique d'origine permettant la réalisation de tests. Ces tests peuvent notamment être réalisés en utilisant des pointes de test qui sont appliquées contre les plots de test.

Toutefois, lors de la mise en oeuvre d'un procédé de préparation du circuit électronique pour la mise en oeuvre d'un collage moléculaire hybride, il peut être observé des connexions indésirables entre les plots de test et des plots HBM.

### Résumé de l'invention

Ainsi, un objet d'un mode de réalisation est de pallier au moins en partie les inconvénients des circuits électroniques adaptés pour un collage moléculaire hybride décrits précédemment.

Un autre objet d'un mode de réalisation est qu'un test du bon fonctionnement du circuit électronique puisse être réalisé avant le collage moléculaire hybride.

Un mode de réalisation prévoit un circuit électronique comprenant une face destinée à être fixée à un autre circuit électronique par collage moléculaire hybride. Le circuit électronique comprend une couche isolante électriquement exposée sur ladite face, et, répartis dans la couche isolante électriquement, des premiers plots de collage conducteurs électriquement exposés sur une première partie de ladite face, la densité des premiers plots de collage sur la première partie de ladite face étant inférieure à 30 %, et au moins un plot de test conducteur électriquement, exposé sur une deuxième partie de ladite face contenant un carré de côté supérieur à 30 µm, la densité de matériau conducteur électriquement du plot de test exposé sur la deuxième partie de ladite face étant comprise entre 40 % et 80 % et, partout dans la deuxième partie de ladite face, au moins une dimension du matériau conducteur électriquement du plot de test exposé sur la deuxième partie de ladite face étant inférieure à 10 µm.

Selon un mode de réalisation, le plot de test comprend une couche conductrice électriquement exposée sur ladite face et traversée par des ouvertures contenant un matériau isolant électriquement.

Selon un mode de réalisation, le plot de test comprend des deuxièmes plots de collage conducteurs électriquement exposés sur ladite face et latéralement séparés par la couche isolante électriquement.

Selon un mode de réalisation, le plot de test a la même composition que les premiers plots de collage.

Selon un mode de réalisation, la densité de matériau conducteur électriquement du plot de test exposé sur la deuxième partie de ladite face est comprise entre 50 % et 80 %.

Selon un mode de réalisation, partout dans la deuxième partie, au moins une dimension du matériau conducteur électriquement du plot de test exposé sur la deuxième partie de ladite face est inférieure à 5 µm.

Un mode de réalisation prévoit également un procédé comprenant la fabrication d'un circuit électronique comprenant une face destinée à être fixée à un autre circuit électronique par collage moléculaire hybride, le circuit électronique comprenant une couche isolante électriquement exposée sur ladite face, et, répartis dans la couche isolante électriquement, des premiers plots de collage conducteurs électriquement exposés sur une première partie de ladite face, la densité des premiers plots de collage sur la première partie de ladite face étant inférieure à 30 %, et au moins un plot de test conducteur électriquement, exposé sur une deuxième partie de ladite face contenant un carré de côté supérieur à 30 µm, la densité de matériau conducteur électriquement du plot de test exposé sur la deuxième partie de ladite face étant comprise entre 40 % et 80 % et, partout dans la deuxième partie de ladite face, au moins une dimension du matériau conducteur électriquement du plot de test exposé sur la deuxième partie de ladite face étant inférieure à 10 µm.

Selon un mode de réalisation, le procédé comprend le collage moléculaire hybride de ladite face à un autre circuit électronique

Selon un mode de réalisation, le procédé comprend en outre une étape de test du fonctionnement du circuit électronique en utilisant le plot de test avant l'étape de collage moléculaire hybride.

Selon un mode de réalisation, le procédé comprend en outre une étape de planarisation de ladite face après l'étape de test et avant l'étape de collage moléculaire hybride.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un plot de test d'un circuit électronique après une opération de test ;
la figure 2 est une image d'un plot de test après une opération de test ;
la figure 3 est une courbe de profil du plot de test de la figure 2 ;
la figure 4 est une vue en coupe latérale, partielle et schématique, d'un exemple de circuit électronique adapté à un collage moléculaire hybride ;
la figure 5 est une vue en coupe de dessus du circuit électronique de la figure 4 ;
la figure 6 est une vue en coupe latérale, partielle et schématique, d'un exemple de circuit électronique comprenant des plots de test ;
la figure 7 est une vue en coupe de dessus du circuit électronique de la figure 6 ;
la figure 8 est une vue en coupe latérale, partielle et schématique, d'un mode de réalisation d'un circuit électronique adapté à un collage moléculaire hybride et comprenant des plots de test ;
la figure 9 est une vue en coupe de dessus du circuit électronique de la figure 8 ;
la figure 10 est une vue en coupe de dessus d'une variante du circuit électronique de la figure 8 ;
la figure 11 représente, par un schéma par blocs, un mode de réalisation d'un procédé de fabrication d'un système électronique ;
la figure 12 représente une courbe de profil de la face de collage d'un circuit électronique et une image partielle de la face de collage illustrant des défauts de collage avec collage moléculaire hybride pour, en partie gauche, une rangée de plots de test selon les figures 6 et 7, et, en partie droite, une rangée de plots de test selon les figures 8 et 9 ; et
la figure 13 représente une image de la face de collage d'une plaque de circuits électroniques pour lesquels des tests ont été réalisés, pour, en partie gauche, des plots de test selon les figures 6 et 7, et, en partie droite, des plots de test selon les figures 8 et 9.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un circuit électronique dans une position normale d'utilisation. Sauf précision contraire, les expressions "environ", "approximativement", "sensiblement", et "de l'ordre de" signifient à 10 % près, de préférence à 5 % près. Dans la suite de la description, le terme "conducteur" signifie conducteur électriquement et le terme "isolant" signifie isolant électriquement.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

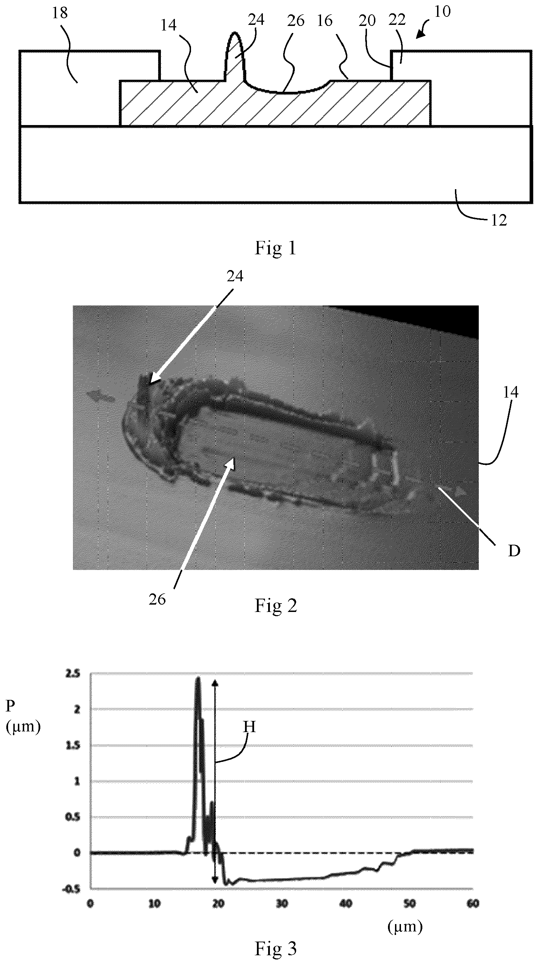

La figure 1 est une vue en coupe, partielle et schématique, d'un circuit électronique 10 comprenant une base 12, contenant le substrat du circuit électronique, des composants électroniques, notamment des transistors, et les niveaux de métallisation inférieurs du circuit électronique 10. Le circuit électronique 10 comprend en outre au moins un plot conducteur 14, appelé plot de test par la suite, utilisé pour des opérations de test avant la préparation du circuit électronique 10 à un collage moléculaire, le plot de test 14 reposant sur la base 12 et comprenant une face supérieure 16. Le circuit électronique 10 comprend, en outre, une couche isolante 18 recouvrant la base 12 et la périphérie du plot de test 14. La couche isolante 18 est généralement formée sur la totalité de la base 12 et du plot de test 14 et une partie de la face supérieure 16 du plot de test 14 est exposée en gravant localement une ouverture 20 dans la couche isolante 18, ce qui entraîne la formation d'une marche abrupte 22 à la périphérie de la zone exposée du plot de test 14 ayant une hauteur de 500 nm à 3 µm. En outre, l'application de pointes de test sur le plot de test 14 entraine la déformation de la face supérieure 16 du plot de test 14, ce qui a été illustré par la formation d'une aspérité 24 et d'un creux 26 représentés de façon schématique en figure 1.

La figure 2 est une image obtenue par interférométrie d'un plot de test 14 en cuivre après une opérations de test. On observe notamment une aspérité 24 et un creux 26.

La figure 3 représente une courbe d'évolution du profil P, exprimé en micromètre, de la surface du plot de test 14 de la figure 2 selon la direction D, exprimée en micromètre, indiquée en figure 2. L'écart maximal H entre le sommet de l'aspérité 24 et le fond du creux 26 est d'environ 3 µm. De façon générale, les inventeurs ont mis en évidence que des écarts H variant de 150 nm à 5 µm peuvent être observés.

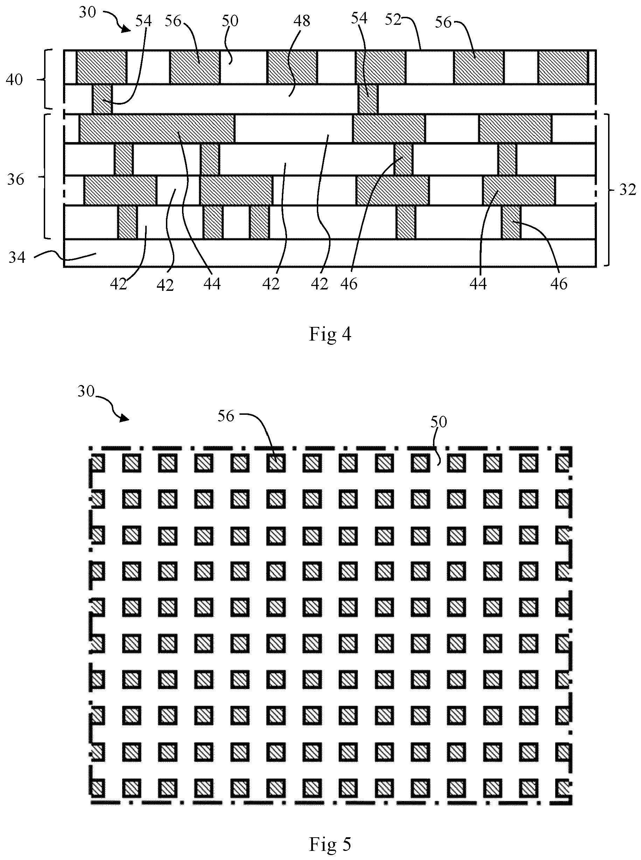

Les figures 4 et 5 sont respectivement une vue en coupe latérale et une vue en coupe de dessus, partielles et schématiques, d'un exemple de circuit électronique adapté à un collage moléculaire hybride.

Le circuit électronique 30 comprend un circuit électronique d'origine 32, dont on a représenté une base 34, contenant le substrat du circuit électronique, des composants électroniques, notamment des transistors, et éventuellement les niveaux de métallisation inférieurs du circuit électronique 30, recouverte de niveaux d'interconnexion supérieurs 36, le circuit électronique d'origine 32 étant recouvert d'un niveau d'interconnexion de collage 40 pour la réalisation d'un collage moléculaire hybride.

Les niveaux d'interconnexion 36 comprennent un empilement de couches isolantes 42, quatre couches isolantes 42 étant représentées à titre d'exemple en figure 4, entre lesquelles et au travers desquelles sont prévus des pistes conductrices 44 et des vias conducteurs 46 reliés aux composants électroniques, non représentés, de la base 34. Le niveau d'interconnexion de collage 40 comprend généralement un empilement d'une couche isolante inférieure 48 et d'une couche isolante supérieure 50. La couche isolante supérieure 50 délimite une face de collage plane 52. Des vias conducteurs 54, appelés HBV par la suite, s'étendent au travers de la couche isolante inférieure 48 et viennent au contact de pistes conductrices 44. Des plots conducteurs de collage 56, appelés plots HBM par la suite, affleurent la face de collage 52. Certains plots HBM 56 sont connectés électriquement à des HBV 54, mais d'autres plots HBM 56 peuvent ne pas être connectés électriquement à des HBV 54. A titre de variante, le niveau d'interconnexion de collage 40 peut comprendre un empilement de plus de deux couches isolantes.

La figure 5 est une vue en coupe de dessus dans un plan parallèle à la face de collage 52 et coupant les plots HBM 56. Comme cela apparaît sur cette figure, les plots HBM 56 peuvent avoir les mêmes dimensions, dans le présent exemple une section carrée en vue de dessus. La section droite de chaque plot HBM 56 peut être, en vue de dessus, inscrite dans un carré dont le côté est inférieur à 10 µm, de préférence inférieur à 7 µm, plus préférentiellement inférieur à 5 µm, encore plus préférentiellement inférieur à 3 µm, en particulier inférieur à 1 µm. Les plots HBM 56 sont séparés par la couche isolante 50 d'une distance minimale qui dépend notamment des dimensions des plots HBM 56, et qui peut être supérieure à 500 nm, de préférence supérieure à 1 µm, plus préférentiellement supérieure à 3 µm, encore plus préférentiellement supérieure à 5 µm. En outre, les plots HBM 56 peuvent être répartis de façon sensiblement homogène sur la face de collage 52.

Chaque plot HBM 56 peut avoir une structure monocouche ou une structure multicouche. Selon un mode de réalisation, la couche ou chaque couche du plot HBM 56 peut être en un matériau métallique utilisé pour la réalisation de niveaux d'interconnexion. Selon un mode de réalisation, la couche ou chaque couche du plot HBM 56 peut être en aluminium (Al), en cuivre (Cu), en alliage de cuivre et d'aluminium, en titane (Ti), en nitrure de titane (TiN), en niobium (Nb), en tungstène (W), ou en cobalt (Co) . Selon un mode de réalisation, chaque plot HBM 56 peut être formé sur une couche ou un empilement de couches jouant le rôle d'accroche pour la formation du plot HBM 56 et/ou de barrière pour la diffusion du matériau composant le plot HBM 56. A titre d'exemple, la couche d'accroche peut être en titane (Ti) ou en nitrure de titane (TiN). La couche d'accroche peut avoir une épaisseur variant de 50 nm à 150 nm, par exemple égale à environ 70 nm. Selon un mode de réalisation, l'épaisseur de chaque plot HBM 56 est comprise entre 500 nm et 1,5 µm, par exemple égale à environ 975 nm.

Chaque couche isolante 48 et 50 peut avoir une structure monocouche ou une structure multicouche. Selon un mode de réalisation, la couche unique formant la couche isolante 48, 50 ou chaque couche de la couche isolante 48, 50 est en oxyde de silicium (SiO₂) , en nitrure de silicium (SiN) , en silane, ou en orthosilicate de tétraéthyle (TEOS). Selon un mode de réalisation, l'épaisseur totale de la couche isolante 48 ou 50 est comprise entre 100 nm et 4 µm.

La face de collage 52 peut être définie par une étape de CMP. La CMP utilise une suspension chimique abrasive et corrosive (généralement un colloïde) en conjonction avec un tampon de polissage maintenu sur une tête de polissage. Le tampon et la plaquette de circuits électroniques sont pressés l'un contre l'autre. Le tampon a une rugosité généralement de l'ordre de 50 µm. La tête de polissage et la plaquette sont mises en rotation selon des axes parallèles et non concentriques, de sorte que le tampon frotte contre la plaquette et entraîne un retrait de matière par action mécanique. La suspension chimique abrasive et corrosive est projetée par une buse sur la plaquette entraîne un retrait de matière par gravure chimique et par action mécanique. Pour que l'étape de planarisation de la face de collage 52 par CMP permette l'obtention de l'état de surface souhaité, la densité locale de matériau conducteur exposé sur la face de collage 52 est généralement choisie inférieure ou égale à 30 %, de préférence comprise entre 20% et 30 %, par exemple environ égale à 25 %.

Dans le cas où la préparation du circuit électronique à un collage moléculaire hybride est réalisée après une opération de test du circuit électronique, le plot de test 14, décrit précédemment, peut être réalisé par l'une des pistes conductrices 44. Les inventeurs ont mis en évidence que les défauts de surface au niveau de plots de test du circuit électronique peuvent empêcher le bon déroulement des procédés connus de préparation du circuit électronique pour un collage moléculaire hybride. En particulier, lors de la préparation du circuit électronique pour la réalisation d'un collage moléculaire hybride, les inventeurs ont mis en évidence que la couche isolante 48 inférieure du niveau d'interconnexion de collage 40 qui est déposée et qui recouvre le plot de test peut ne pas être suffisamment épaisse pour compenser les irrégularités du relief en surface du circuit électronique d'origine 32, en particulier lorsqu'une CMP est réalisée ultérieurement, de sorte que l'aspérité 26, décrite précédemment, du plot de test 14 peut être exposée.

On pourrait envisager d'augmenter l'épaisseur de l'empilement de couches isolantes du niveau d'interconnexion de collage 40, en particulier l'épaisseur de la couche isolante 48 inférieure déposée sur le plot de test et dans laquelle sont formés les HBV 54. Toutefois, ceci peut ne pas être possible, d'une part en raison du rapport d'aspect hauteur/largeur qui en résulterait pour les ouvertures à réaliser dans cette couche isolante 48 pour former les HBV 54 qui peuvent ne pas être compatibles avec les techniques utilisées pour former ces ouvertures, et d'autre part, en raison de l'augmentation des résistances électriques de ces HBV 54 qui en résulterait et qui peut ne pas être compatible avec les propriétés électriques souhaitées pour le niveau d'interconnexion de collage 40.

On pourrait envisager de réaliser le plot de test dans le niveau d'interconnexion de collage 40, le plot de test étant réalisé simultanément avec les plots HBM 56.

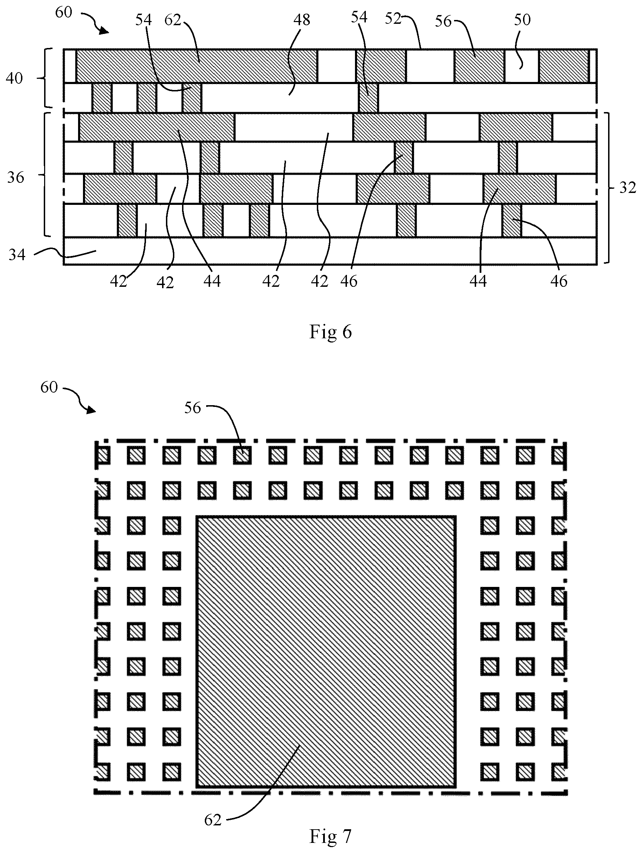

Les figures 6 et 7 sont des vues respectivement analogues aux figures 4 et 5 d'un exemple de circuit électronique 60 adapté à un collage moléculaire hybride qui comprend l'ensemble des éléments du circuit électronique 30 représenté sur les figures 4 et 5 à la différence qu'il comprend en outre au moins un plot de test 62, en général plusieurs plots de test, formé dans le même niveau que les plots HBM 56. Le plot de test 62 a la même composition que celle des plots HMB 56 décrite précédemment.

Toutefois, les dimensions du plot de test 62 sont généralement imposées par les outils utilisés pour réaliser le test. En particulier, pour l'application de pointes de test sur le plot de test, le plot de test doit avoir, en vue de dessus, une section droite dans laquelle est inscrit un carré dont la dimension du côté est supérieure à 30 µm, de préférence supérieure à 40 µm, par exemple égale à environ 70 µm. Ceci peut ne pas être compatible avec l'obtention par CMP d'un état de surface convenable pour la face de collage 52.

En effet, de façon générale, un procédé CMP entraîne toujours une surgravuve (en anglais "dishing") des plots HBM 56 par rapport à la couche diélectrique 50 qui les entoure. Cette surgravure augmente avec les dimensions du plot HBM 56. Lors de la mise en contact des faces de collage de deux circuits électroniques pour réaliser un collage hybride moléculaire, seule les régions diélectriques vont se coller, les plots HBM ne se collant généralement pas en raison de la surgravure. Toutefois, la mise en contact est suivie d'une étape de recuit thermique. Celui-ci entraîne une dilation des plots HBM plus importante que la dilation des régions diélectriques et une mise en contact des plots HBM des deux circuits électroniques qui restent collés à la fin du recuit. C'est pourquoi la section droite d'un plot HBM en vue de dessus reste de façon générale inférieure à un carré de 10 µm de côté pour que la surgravure ne soit pas trop profonde et reste compatible avec l'étape de recuit qui suit le collage hybride. Toutefois, pour le plot de test 62, la surgravure obtenue après l'étape de CMP délimitant la face de contact 52 est trop importante de sorte que, après l'étape de recuit thermique, un défaut local de collage entre les deux circuits électroniques peut être observé au niveau du plot de test 62.

En outre, l'application de pointes de test sur le plot de test 62 peut entrainer la déformation de la surface du plot de test 62 et notamment la formation d'aspérités en surface du plot de test 62 qui peuvent être importantes comme cela a été décrit précédemment en relation avec la figure 3, de sorte qu'une CMP ultérieure ne permette pas l'obtention de la face de collage 52 avec un état de surface convenable pour réaliser un collage moléculaire hybride.

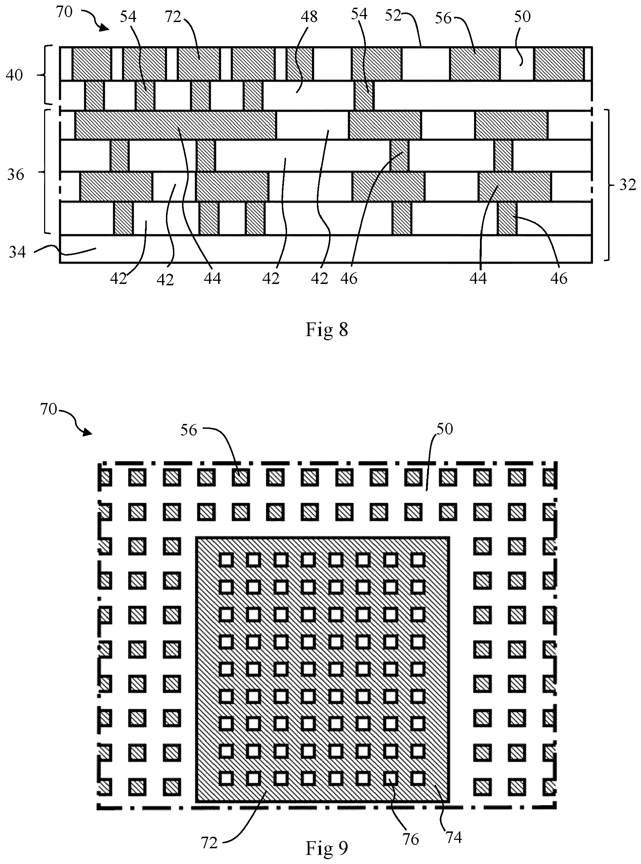

Les figures 8 et 9 sont des vues respectivement analogues aux figures 6 et 7 d'un mode de réalisation d'un circuit électronique 70 adapté à un collage moléculaire hybride qui comprend l'ensemble des éléments du circuit électronique 60 représenté sur les figures 6 et 7 à la différence que chaque plot de test 62 est remplacé par un plot de test 72, un seul plot de test étant représenté sur les figures 8 et 9.

Chaque plot de test 72 correspond à une structure pour laquelle la densité de matériau conducteur affleurant la face de collage 52 est supérieure à 40 %, de préférence comprise entre 40 % et 80 %, plus préférentiellement comprise entre 50 % et 70 %. La densité de matériau conducteur exposé sur la face de collage 52 en dehors de chaque plot de test 72 est inférieure à 35 %, de préférence inférieure à 30 %, plus préférentiellement inférieure à 25 %. Le plot de test 72 est inscrit en vue de dessus dans un carré dont le côté est compris entre 30 µm et 100 µm. Le plot de test 72 a la même composition que celle des plots HMB 56 décrite précédemment. Le plot de test 72 a une structure telle que, en n'importe quel point du plot de test 72 exposé sur la face de collage 52, une dimension du plot de test passant par ce point est inférieure à 10 µm, de préférence inférieure à 5 µm.

Dans le mode de réalisation représenté en figure 9, le plot de test 72 comprend une couche conductrice 74 traversée par des ouvertures 76 contenant le matériau isolant de la couche isolante 50. Chaque ouverture 76 peut avoir, en vue de dessus, une section droite inscrite dans un carré dont le côté est compris entre 2 µm et 7 µm, par exemple égal à environ 5 µm. La distance minimale entre deux ouvertures 76 adjacentes peut être supérieure à 2 µm, de préférence supérieure à 5 µm.

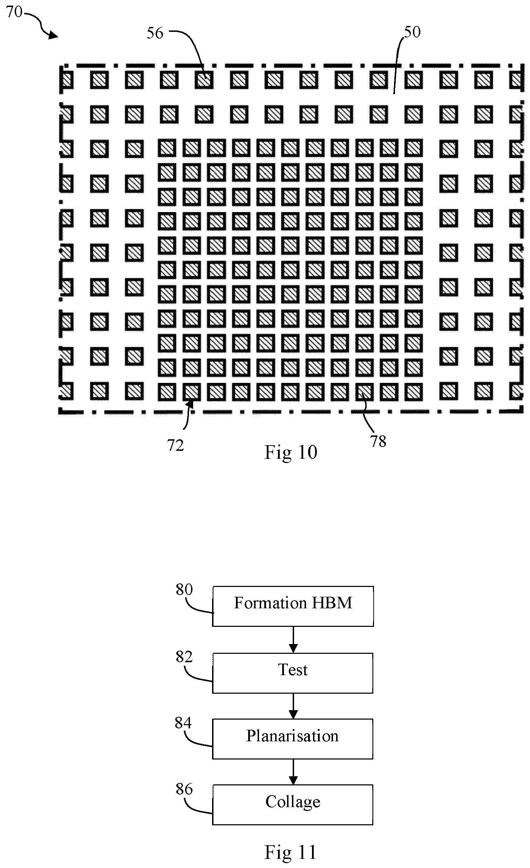

La figure 10 est une figure analogue à la figure 9 représentant une variante du circuit électronique 70 dans laquelle le plot de test 72 correspond à un ensemble de plots conducteurs 78 séparés les uns des autres par la couche isolante 50. Les plots 78 peuvent avoir les mêmes dimensions que les plots HBM 56, la densité locale des plots 78 étant supérieure à la densité locale des plots HBM 56. La majorité des plots 78 sont connectés aux pistes conductrices 44 par des HBV 54. De préférence, chaque plot 78 est connecté à l'une des pistes conductrices 44 par un HBV 54.

Selon une autre variante, au moins une partie du plot de test 72 peut avoir la structure décrite précédemment en relation avec la figure 9, c'est-à-dire comprendre une couche conductrice 72 traversée par des ouvertures 76 contenant un matériau isolant, et au moins une autre partie du plot de test peut avoir la structure décrite précédemment en relation avec la figure 10, c'est-à-dire comprendre un ensemble dense de plots conducteurs 78 latéralement séparés par la couche isolante supérieure 50.

La figure 11 représente, par un schéma par blocs, un mode de réalisation d'un procédé de fabrication d'un système électronique comprenant un premier circuit électronique 70, tel que décrit précédemment, fixé à un deuxième circuit électronique par collage hybride moléculaire.

A une étape 80, le procédé comprend, pour chacun des circuits électroniques, la formation du niveau d'interconnexion de collage 40 du circuit électronique 70 comprenant au moins un plot de test 72. Le procédé se poursuit à l'étape 82. Les plots HBM 56, les HBV 54, et les plots de test 72 peuvent être formés selon un procédé de fabrication dans lequel les HBV 54 et les plots HBM 56 sont réalisés par des étapes distinctes de dépôt d'un matériau conducteur, par exemple par un procédé du type simple damascène. A titre de variante, les HBV 54 et les plots HBM 56 peuvent être formés en une seule étape de dépôt d'un matériau conducteur, par exemple par un procédé du type double damascène.

A une étape 82, qui est optionnelle, le procédé comprend la réalisation de tests du bon fonctionnement du circuit électronique 70 en utilisant les plots de test 72 formés à l'étape 80. Le test peut comprendre la mise en contact de chaque plot de test 72 avec une pointe. Le procédé se poursuit à l'étape 84.

A une étape 84, qui est mise en oeuvre seulement lorsqu'un test a été effectué à l'étape 82, une planarisation de la face de collage 52 est réalisée. Ceci peut être réalisé par CMP. Cette étape permet l'obtention d'une face de collage 52 avec un état de surface adapté à la réalisation d'un collage moléculaire hybride. Le procédé se poursuit à l'étape 86. Les inventeurs ont mis en évidence que, avec la structure des plots de test décrites précédemment, une face de collage 52 avec un état de surface adapté à la réalisation d'un collage moléculaire hybride peut être obtenue par CMP même lorsqu'un test a été effectué. Après l'étape de planarisation, l'écart maximal entre les creux et les crêtes présentes sur la face de collage 52 est inférieur à 50 nm, de préférence inférieur à 20 nm.

A une étape 86, un collage moléculaire hybride est réalisé par la mise en contact des faces de collage 52 des deux circuits électroniques 70. L'étape de mise en contact peut être suivie d'un recuit thermique.

Des essais ont été réalisés. Pour un premier essai, deux premières plaques de circuits électroniques ont été fabriquées avec des plots de test 62 ayant chacun la structure selon les figures 6 et 7. Une mesure d'une courbe de profil de la face de collage 52 de l'une des premières plaques a été réalisée. Il n'y a pas eu d'étape de test. Un collage hybride moléculaire a été réalisé entre les deux premières plaques de circuits électroniques. Une image des faces de collage collées l'une à l'autre a été déterminée par analyse par ultrasons sur le système électronique obtenu après collage moléculaire hybride, les défauts de collage apparaissant sous la forme de pixels plus clairs sur l'image.

Pour un deuxième essai, deux deuxièmes plaques de circuits électroniques ont été fabriquées avec des plots de test 72 ayant chacun la structure selon les figures 8 et 9. Une mesure de la courbe de profil de la face de collage de l'une des deuxièmes plaques a été réalisée. Il n'y a pas eu d'étape de test. Un collage hybride moléculaire a été réalisé entre les deux deuxièmes plaques de circuits électroniques. Une image des faces de collage collées l'une à l'autre a été déterminée par analyse par microscopie acoustique à balayage sur le système électronique obtenu après collage moléculaire hybride.

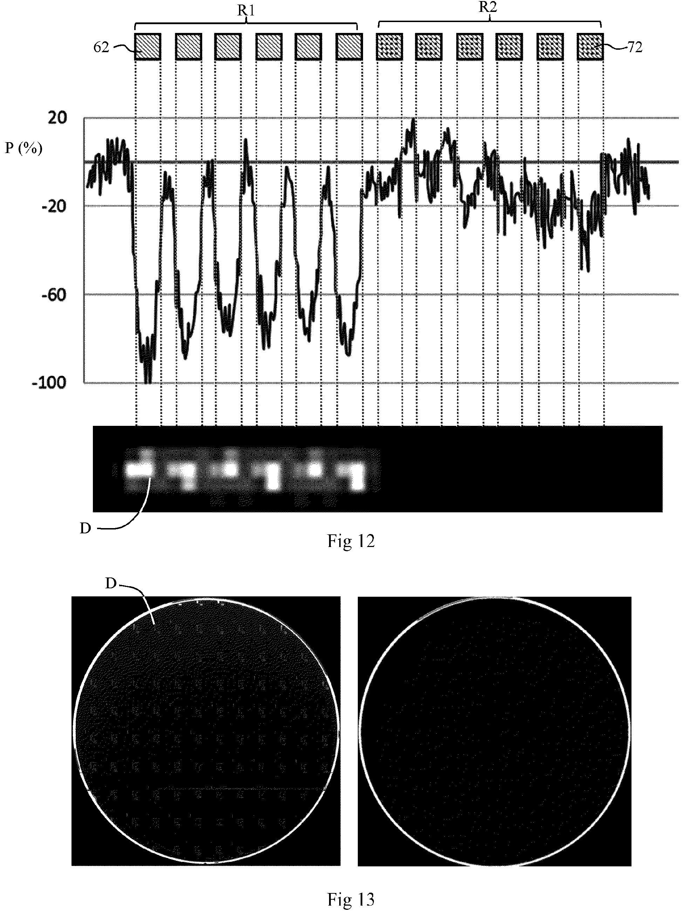

La figure 12 représente, en partie centrale, une courbe de profil P, exprimée en pourcentage, de la face de collage d'un circuit électronique et, en partie basse, une image partielle de la face de collage illustrant d'éventuelles défauts de collage pour, en partie gauche, une rangée R1 de plots de test 62 de la première plaque, et, en partie droite, une rangée R2 de plots de test 72 de la deuxième plaque.

Comme cela apparaît sur cette figure, lorsque les plots de test 62 ont la structure selon les figures 6 et 7, la courbe de profil n'est pas compatible avec un collage moléculaire hybride, ce qui se traduit par des défauts de collage (pixels blancs D). Lorsque les plots de test ont la structure selon les figures 8 et 9, la courbe de profil obtenue est compatible avec un collage moléculaire hybride, ce qui se traduit par une absence de défauts de collage.

Des troisième et quatrième essais ont été réalisés. Le troisième essai est identique au premier essai à la différence qu'une étape de test suivie d'une étape de planarisation par CMP ont été mises en oeuvre avant le collage moléculaire hybride. Le quatrième essai est identique au deuxième essai à la différence qu'une étape de test suivie d'une étape de planarisation par CMP ont été mises en oeuvre avant le collage moléculaire hybride.

La figure 13 représente une image déterminée par analyse par microscopie acoustique de la face de collage 52 des plaques de circuits électroniques du troisième essai en partie gauche et du quatrième essai en partie droite.

Comme cela apparaît sur cette figure, lorsque les plots de test 62 ont la structure selon les figures 6 et 7, des défauts de collage sont observés (pixels blancs D). Lorsque les plots de test 72 ont la structure selon les figures 8 et 9, aucun défaut de collage n'est observé, ce qui signifie que l'étape de planarisation qui suit l'étape de test permet de retrouver un état de surface compatible avec le collage moléculaire hybride.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En outre, bien que des modes de réalisation décrits précédemment concernent un dispositif électronique qui comprend l'empilement de deux circuits électroniques, il est clair que le dispositif électronique peut comprendre un empilement de plus de deux circuits électroniques, les modes de réalisation décrits précédemment pouvant s'appliquer à chaque interface entre deux circuits électroniques adjacents de l'empilement.

Enfin, la mise en oeuvre pratique des modes de réalisation et variantes décrits est à la portée de la personne du métier à partir des indications fonctionnelles données ci-dessus.

## Revendications

1. Circuit électronique (70) comprenant une face (52) destinée à être fixée à un autre circuit électronique par collage moléculaire hybride, le circuit électronique comprenant :
une couche isolante électriquement (50) exposée sur ladite face ;
répartis dans la couche isolante électriquement, des premiers plots de collage (56) conducteurs électriquement exposés sur une première partie de ladite face, la densité des premiers plots de collage sur la première partie de ladite face étant inférieure à 30 % ; et
au moins un plot de test (72) conducteur électriquement, exposé sur une deuxième partie de ladite face contenant un carré de côté supérieur à 30 µm, la densité de matériau conducteur électriquement du plot de test exposé sur la deuxième partie de ladite face étant comprise entre 40 % et 80 % et, partout dans la deuxième partie de ladite face, au moins une dimension du matériau conducteur électriquement du plot de test exposé sur la deuxième partie de ladite face étant inférieure à 10 µm.

2. Circuit électronique selon la revendication 1, dans lequel le plot de test (72) comprend une couche conductrice électriquement (74) exposée sur ladite face (52) et traversée par des ouvertures (76) contenant un matériau isolant électriquement.

3. Circuit électronique selon la revendication 1 ou 2, dans lequel le plot de test (72) comprend des deuxièmes plots de collage (78) conducteurs électriquement exposés sur ladite face (52) et latéralement séparés par la couche isolante électriquement (50).

4. Circuit électronique selon l'une quelconque des revendications 1 à 3, dans lequel le plot de test (72) a la même composition que les premiers plots de collage (56).

5. Circuit électronique selon l'une quelconque des revendications 1 à 4, dans lequel la densité de matériau conducteur électriquement du plot de test (72) exposé sur la deuxième partie de ladite face est comprise entre 50 % et 80 %.

6. Circuit électronique selon l'une quelconque des revendications 1 à 5, dans lequel partout dans la deuxième partie, au moins une dimension du matériau conducteur électriquement du plot de test (72) exposé sur la deuxième partie de ladite face (52) est inférieure à 5 µm.

7. Procédé comprenant la fabrication d'un circuit électronique (70) comprenant une face (52) destinée à être fixée à un autre circuit électronique par collage moléculaire hybride, le procédé comprenant les étapes de :
formation d'une couche isolante électriquement (50) exposée sur ladite face ;
formation de premiers plots de collage (56) conducteurs électriquement, répartis dans la couche isolante électriquement, exposés sur une première partie de ladite face, la densité des premiers plots de collage sur la première partie de ladite face étant inférieure à 30 % ; et
formation d'au moins un plot de test (72) conducteur électriquement, exposé sur une deuxième partie de ladite face contenant un carré de côté supérieur à 30 µm, la densité de matériau conducteur électriquement du plot de test exposé sur la deuxième partie de ladite face étant comprise entre 40 % et 80 % et, partout dans la deuxième partie de ladite face, au moins une dimension du matériau conducteur électriquement du plot de test exposé sur la deuxième partie de ladite face étant inférieure à 10 µm.

8. Procédé selon la revendication 7, comprenant le collage moléculaire hybride de ladite face (52) à un autre circuit électronique.

9. Procédé selon la revendication 8, comprenant en outre une étape de test du fonctionnement du circuit électronique (70) en utilisant le plot de test (72) avant l'étape de collage moléculaire hybride.

10. Procédé selon la revendication 9, comprenant en outre une étape de planarisation de ladite face (52) après l'étape de test et avant l'étape de collage moléculaire hybride.
